(19) Europäisches Patentamt
European Patent Office
Office européen des brevets

(11) **EP 2 924 475 A1**

(12) **EUROPEAN PATENT APPLICATION**

(43) Date of publication:
**30.09.2015 Bulletin 2015/40**

(51) Int Cl.:
**G01W 1/12** (2006.01)   **G06Q 10/04** (2012.01)
**G01C 21/34** (2006.01)

(21) Application number: **15159184.9**

(22) Date of filing: **16.03.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **19.03.2014   JP 2014055912**

(71) Applicant: **Kabushiki Kaisha Toshiba
Tokyo 105-8001 (JP)**

(72) Inventors:
• **Shin, Hiromasa
Tokyo, 105-8001 (JP)**
• **Maruchi, Kohei
Tokyo, 105-8001 (JP)**
• **Endoh, Yusuke
Tokyo, 105-8001 (JP)**
• **Hasegawa, Yoshiaki
Tokyo, 105-8001 (JP)**

(74) Representative: **Hoffmann Eitle
Patent- und Rechtsanwälte PartmbB
Arabellastraße 30
81925 München (DE)**

(54) **Insolation information generating device, insolation information providing system and insolation information providing method**

(57) An insolation information generating device has a mesh generator to generate meshes by projecting a solar trajectory on a celestial sphere onto a plurality of mesh positions on a two-dimensional plane, a solar position calculator to calculate a solar position, a feature road shape storage to store three-dimensional information on feature and road shapes, a feature road shape acquisition module to acquire three-dimensional information of a feature and a road located around each of a plurality of regions of interest, an insolation information calculator to determine whether sunlight from each solar position calculated by the solar position calculator is blocked by a feature acquired by the feature road shape acquisition module to calculate at least either one of a sunny ratio and a shady ratio, and an insolation information storage to store each mesh position and at least either one of the corresponding sunny ratio and shady ratio.

FIG.1

**Description**

FIELD

Embodiments of the present invention relate to an insolation information generating device, an insolation information providing system, and an insolation information providing method.

BACKGROUND

The ratio of sunny sections (a sunny ratio, hereinafter) in a region of interest in urban areas is a basic numerical value in consideration of solar power systems, building power demand prediction, traffic navigation, etc. For example, if the sunny ratio on the solar cell surface, the building outer wall, etc., can be used at any time with weather data, the power generation amount of solar power systems, the building power demand, etc. can be estimated. Moreover, if the sunny ratios of roads can be used at any time, a route for travelling with many sunny or shady sections can be selected according to the time zone. Thus, it is possible to implement traffic navigation having new values such as protection from sunburn and heat stroke.

The sunny ratio of a region of interest is a quantity determined by a geometrical relationship among the region of interest, the shapes of obstacles to sunlight, and the solar position. Since the calculation of the sunny ratio takes time, it is desirable to prepare a numerical table of calculated sunny ratios in advance. However, the sunny ratio drastically varies depending on the location of region of interest, time, etc., it is required to have a numerical table with a short time interval as possible (for example, an interval of 10 minutes) in order to maintain the accuracy (for example, within 5%). When, for example, a numerical table of sunny ratios is formed at an interval of 10 minutes for one year (from 6 a.m. to 6 p.m.), the numerical table has a 26280-point data amount per road segment. Thus, it is not easy to manage the data for a plurality of road segments in view of the data amount.

BRIEF DESCRIPTION OF THE DRAWINGS

FIG. 1 is a schematic block diagram of an insolation information providing system 1 according to an embodiment of the present invention;
FIG. 2 is a diagram showing the change in solar position on a celestial sphere;
FIG. 3 is a diagram indicating meshes of a plurality of mesh positions 31 on a two-dimensional plane, generated by a mesh generator 11;
FIG. 4 is a graph showing one example of change in sunny ratio with time per road segment in urban areas;
FIG. 5 is a flowchart showing one example of a procedure performed by an insolation information generating device 2 of FIG. 1;
FIG. 6 is a flowchart showing one example of a detailed process of step S6 of FIG. 5;
FIG. 7 is a diagram showing one example of image data indicating a ground shade range;
FIG. 8 is a flowchart showing one example of a procedure performed by an insolation information reference device 3 of FIG. 1; and
FIG. 9 is a schematic block diagram of an insolation information providing system 1 according to a second embodiment.

DETAILED DESCRIPTION

An insolation information generating device according to one embodiment has the following configuration. A mesh generator generates meshes by projecting a solar trajectory on a celestial sphere onto a plurality of mesh positions on a two-dimensional plane. A solar position calculator calculates a solar position expressed by a solar altitude and a solar azimuth for each mesh position in the meshes. A feature road shape storage stores three-dimensional information on feature and road shapes. A feature road shape acquisition module acquires three-dimensional information of a feature and a road located around each of a plurality of regions of interest from the feature road shape storage. An insolation information calculator determines whether sunlight from each solar position calculated by the solar position calculator is blocked by a feature acquired by the feature road shape acquisition module in each region of interest and to calculate at least either one of a sunny ratio that indicates how much each region of interest is irradiated with the sunlight with respect to an area of the region of interest and a shady ratio that indicates how much each region of interest is not irradiated with the sunlight with respect to the area of the region of interest. An insolation information storage stores each mesh position and at least either one of the corresponding sunny ratio and shady ratio in association with each other, for each of the plurality of regions of interest.

Hereinafter, embodiments of the present invention will be described with reference to the accompanying drawings. In the following embodiments, the unique configuration and operation in an insolation information providing system will be mainly explained. The insolation information providing system may have other configuration and operation that are omitted from the follow explanation. The omitted configuration and operation also fall within the scope of the embodiments.

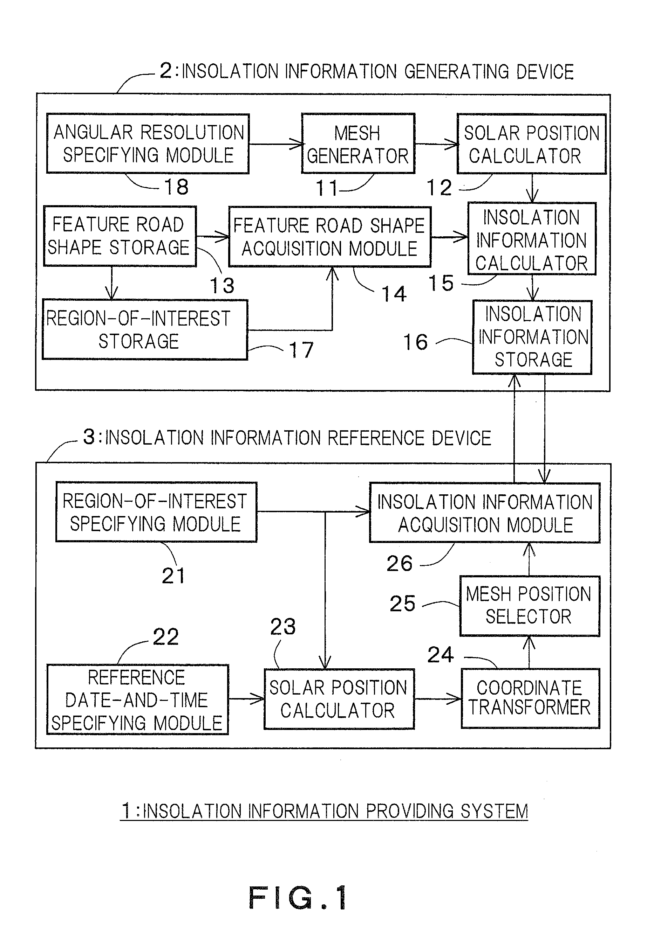

FIG. 1 is a schematic block diagram of an insolation information providing system 1 according to an embodiment of the present invention.

The insolation information providing system 1 of FIG. 1 has an insolation information generating device 2 and an insolation information reference device 3. The insolation information generating device 2 and the insolation information reference device 3 may have different hardware configurations or have a single hardware configuration (such as a computer). Or at least either the insolation information generating device 2 or the insolation information reference device 3 may be configured with software. Information transmission and reception between the insolation information generating device 2 and the insolation information reference device 3 may be performed with wired or wireless communications. Furthermore, the insolation information generating device 2 and the insolation information reference device 3 may perform information transmission and reception via a network such as the Internet.

The insolation information generating device 2 of FIG. 1 has, as the essential components, a mesh generator 11, a solar position calculator (first solar position calculator) 12, a feature road shape storage 13, a feature road shape acquisition module 14, an insolation information calculator 15, and an insolation information storage 16.

The mesh generator 11 generates meshes by projecting the solar trajectory on a celestial sphere onto a plurality of mesh positions on a two-dimensional plane. The celestial sphere, meshes and the two-dimensional plane will be explained later in detail.

The solar position calculator 12 calculates a solar position expressed by a solar altitude and a solar azimuth for each mesh position generated by the mesh generator 11.

The feature road shape storage 13 stores three-dimensional information on the shapes of features and roads. The features are three-dimensional objects such as architectural structures and forests. The roads include road information with widths and road information with line segments having no widths.

The feature road shape acquisition module 14 acquires three-dimensional information of features and roads located around each of a plurality of regions of interest. The features and roads located around each region of interest are the features and roads which may block sunlight supposed to reach the region of interest.

The insolation information calculator 15 determines whether sunlight from each solar position calculated by the solar position calculator 12 is blocked by a feature acquired by the feature road shape acquisition module 14 in each region of interest. Then, the insolation information calculator 15 calculates at least either one of a sunny ratio that indicates how much each region of interest is irradiated with the sunlight with respect to the area of the region of interest and a shady ratio that indicates how much each region of interest is not irradiated with the sunlight with respect to the area of the region of interest.

The insolation information storage 16 stores each mesh position and at least either one of the corresponding sunny ratio and shady ratio in association with each other, for each of a plurality of regions of interest. In this specification, the sunny ratio and the shady ratio are referred to as insolation information, as a generic term.

Moreover, the insolation information generating device 2 of FIG. 1 may have at least either one of a region of interest storage 17 and an angular resolution specifying module 18, as an optional component.

The region of interest storage 17 extracts and stores a plurality of regions of interest from the three-dimensional information on feature and road shapes stored in the feature road shape storage 13. The region of interest storage 17 may also store a region of interest not stored in the feature road shape storage 13. For example, broken line data on a road network not stored in the feature road shape storage 13 may be set to be a region of interest. The region of interest is at least one of a surface, a line segment and a point, for which the sunny ratio and/or shady ratio are calculated. The surface is a region having a width and a length, which is not necessarily be a plane, but may have irregularities. The line segment is a region having no width but having a length, which is a concept including a point sequence of a plurality of points. The point is a region with no width and length. One example of the region of interest is one wall surface, that faces a specific direction, of a building stored in the feature road shape storage 13. Another example of the region of interest is each of road segments to which a road is segmented at each intersection. Each road segment in this case may have a width, may be a line segment with no width, or may be a point sequence of a plurality of points.

The angular resolution specifying module 18 specifies angular resolution that expresses an interval of solar positions on the celestial sphere. With the angular resolution specified by the angular resolution specifying module 18, an interval of mesh positions can be arbitrarily changed. The finer the angular resolution, the smaller the interval of the mesh positions, hence a more precise solar motion can be detected.

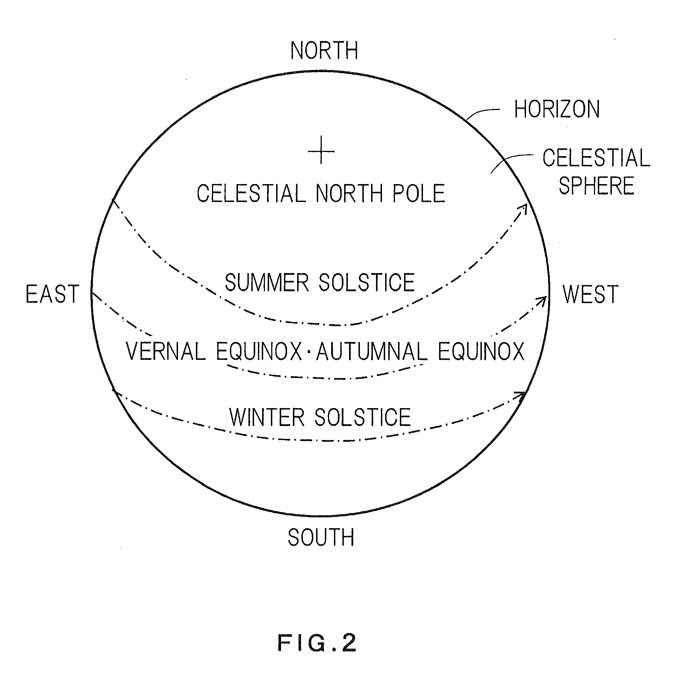

FIG. 2 is a diagram showing the change in solar position on the celestial sphere. Everyday, the sun rises from the east and falls in the west, with the altitude varying depending on the season. FIG. 2 indicates the 1-year solar trajectory on the celestial sphere with dashed lines. The solar positions on the celestial sphere can be expressed by an hour angle and declination. The hour angle is an angle of direction of each solar position with respect to the solar position of directly south as a reference direction. The hour angle varies in the range of $0 \pm 90$ degrees in the vernal and autumnal equinoxes, but varies in the range from 0 degrees to an angle less than $\pm$ 90 degrees except for the vernal and autumnal equinoxes. The declination varies within a range of $\pm$ 23. 4 degrees vertically on the celestial sphere, with the vernal and autumnal equinoxes in the reference direction. In the summer solstice, the declination is 23. 4 degrees. In the winter solstice, the declination is - 23. 4 degrees.

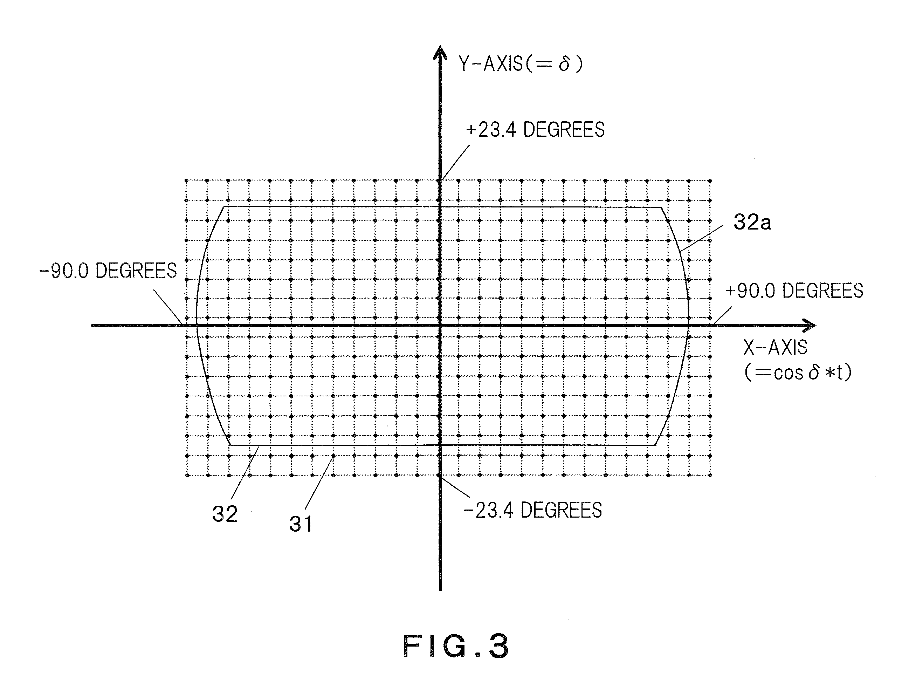

FIG. 3 is a diagram indicating meshes of a plurality of mesh positions 31 on a two-dimensional plane, which are generated by the mesh generator 11. Each mesh position 31 of FIG. 3 represents a solar position. A frame line 32 indicates a region in which the sun moves. The crossings of the frame line 32 with an X-axis are at $\pm$ 90 degrees and that with a Y-axis are at $\pm$ 23. 4 degrees. The X-axis on the two-dimensional plane corresponds to the hour angle. The Y-axis on the two-dimensional plane corresponds to the declination. Since the hour angle taken by the sun varies depending on the season, the both lines of the frame line 32 in the X-axis direction are curves in line symmetry having the Y-axis as a reference. For example, a curve 32a, the right-side edge line, is a curve expressed by $X = 90° \times \cos(Y)$.

The insolation information storage 16 stores at least either one of the sunny ratio and the shady ratio for each mesh position 31 within the frame line 32 of FIG. 3. In other words, mesh positions 31 outside the frame line 32 are not used for calculation of the sunny ratio and shady ratio.

The interval of the mesh positions 31 within the frame line 32 of FIG. 3 can be arbitrarily adjusted. As the resolution of the angular resolution specifying module 18 is set to be higher, the number of mesh positions 31 within the frame line 32 increases, hence more precise solar potions can be detected.

The area S within the frame line 32 is given by the following expression (1).

$$\text{Area } S = 2 \times 180^2 \times \sin(23.\,4) \,/\, \pi \approx 819.\,7 \;[\text{degrees}^2] \cdots (1)$$

When an angular resolution $\Delta\theta$ is set to $\Delta\theta = 2$. 5 degrees that corresponds to the interval of 10 minutes, the number of lattice points N within the frame line 32 is given by the following expression (2).

$$\text{Number of lattice points } N = S \,/\, (\Delta\theta)^2 = 1310 \cdots (2)$$

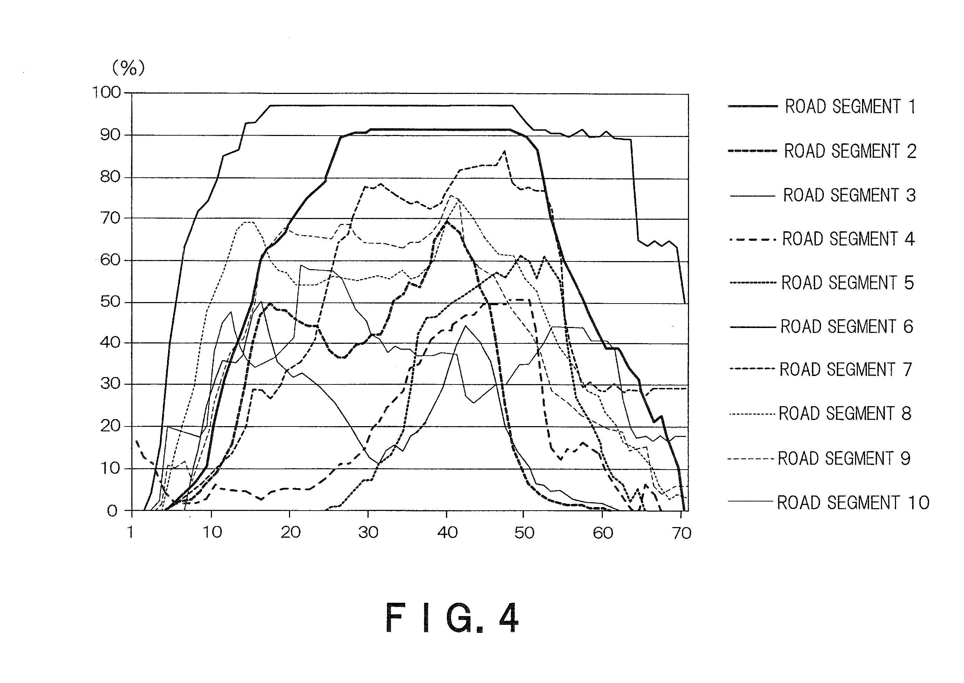

FIG. 4 is a graph showing one example of change in sunny ratio with time per road segment in urban areas. FIG. 4 shows the change in sunny ratio at road segments 1 to 10 from 6 a.m. to 6 p.m. In FIG. 4, the abscissa is time and the ordinate is the sunny ratio. As shown, the sunny ratio drastically varies depending on the time zone and also depending on the road segment. Therefore, in order to estimate the sunny ratio of each road segment, it is preferable to generate a database of sunny ratios measured at a short time interval for each road segment.

For example, when the sunny ratios are put into a numerical table per 10 minutes for one year (from 6 a.m. to 6 p.m.) for each road segment, the number of data pieces is 26280 for each road segment.

Therefore, the compression ratio of a data amount stored in the insolation information storage 16 with a numerical table of sunny ratios at the mesh positions 31 within the frame line 31 only, such as shown in FIG. 3, is 1310 / 26280 $\approx$ 1 / 20. It is understood that the data mount can be drastically reduced. Accordingly, in the present embodiment, the data mount of the insolation information storage 16 can be drastically reduced without reducing the sunny ratio accuracy.

The generation of sunny ratios and/or shady ratio to be stored in the insolation information storage 16 is performed by the insolation information generating device 2.

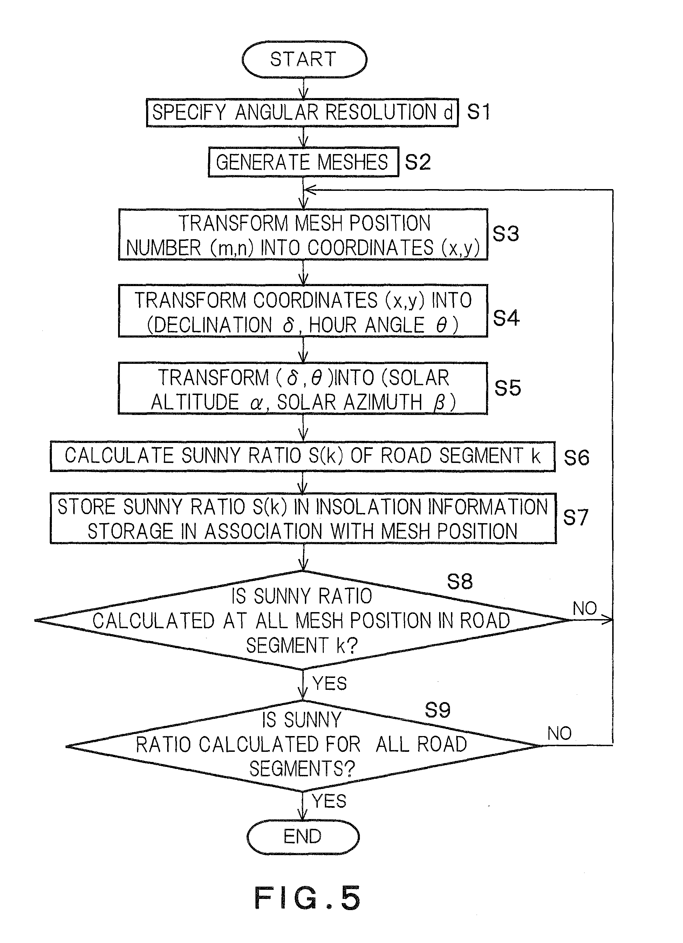

FIG. 5 is a flowchart showing one example of a procedure performed by the insolation information generating device 2 of FIG. 1.

The example to be explained here is that sunny ratios of a plurality of road segments that are regions of interest are stored in the insolation information storage 16. When the shady ratio is stored instead of the sunny ratio or in addition to the sunny ratio, it is possible to execute the same steps.

Firstly, the angular resolution specifying module 18 specifies an angular resolution $\Delta\theta = d$ (step S1). This step S1 may be omitted and a predetermined angular resolution d may be specified.

Next, the mesh generator 11 generates meshes on a two-dimensional plane at an interval corresponding to the specified or predetermined angular resolution d (step S2).

When the time zone for calculating the sunny ratios of road segments is - T to + T, a maximum mesh position M in the X-axis direction and a maximum mesh position N in the Y-axis direction for the meshes within the frame line 32 of FIG. 3 are expressed by the following expressions (3) and (4), respectively.

$$M = [(T / 24) \times (360 / d)] \cdots (3)$$

$$N = [\Delta / d] \cdots (4)$$

In the above expressions (3) and (4), [x] means that x is transformed into an integer, with the fractions after the decimal point rounded down. Δ is 23. 4 degrees, T is a time range, and d is angular resolution.

When given mesh position coordinates in the frame line 32 of FIG. 3 are expressed by (m, n), a variable rate of m and n, and a variable range of a road segment k are expressed as follows.

$$M = - M, \cdots, M \ (2M + 1 \text{ in total})$$

$$N = - N, \cdots, N \ (2N + 1 \text{ in total})$$

$$K = 1, \cdots, k \ (k \text{ in total})$$

The mesh generator 11 transforms the mesh position coordinates (m, n) into coordinates (x, y) based on the following expressions (5) and (6)(step S3).

$$x = m \times d \cdots (5)$$

$$y = n \times d \cdots (6)$$

Next, the solar position calculator 12 calculates a solar position expressed with a solar altitude α and a solar azimuth β from the coordinates (x, y) of the mesh position 31 based on the following expression (7) (steps S4, S5).

$$(\alpha, \beta) = (H \times G) (x, y) \cdots (7)$$

The expression (7) is, in more specifically, derived from the following expressions (8) to (13). Firstly, based on the following expression (8), the coordinates (x, y) are transformed into a coordinate system (declination δ, hour angle θ) (step S4). Step S4 corresponds to a hour angle declination transforming module.

$$(\delta, \theta) = G (x, y) \cdots (8)$$

A function (x, y) of the expression (8) is, in more specifically, expressed by the following expressions (9) and (10).

$$\Delta = y \cdots (9)$$

$$\theta = x / \cos(y) \cdots (10)$$

Next, based on the following expression (11), the coordinate system is transformed from (declination δ, hour angle θ) into a coordinate system of (solar altitude α, solar azimuth β) (step S5).

$$(\alpha, \beta) = H (\delta, \theta) \cdots (11)$$

A function $(\delta, \theta)$ of the expression (11) is, in more specifically, expressed by the following expressions (12) and (13). In the following, $\lambda$ is a latitude of a road segment.

$$\sin\alpha = \sin(\lambda)\sin(\delta) + \cos(\lambda)\cos(\delta)\cos(\theta) \cdots (12)$$

$$\tan\beta = \cos(\lambda)\text{con}(\delta)\sin(\theta) / \{\sin(\lambda)\sin(\alpha) - \sin(\delta)\} \cdots (13)$$

When a solar position is calculated in step S5 of FIG. 5, the insolation information calculator 15 refers to the feature road shape storage 13 to calculate a sunny ratio S(k) of a road segment k (step S6).

Step S6 will be explained later in detail.

Next, the insolation information calculator 15 stores the calculated sunny ratio S(k) in the insolation information storage 16, in association with the mesh position 31 (x, y) (step S7).

Next, it is determined whether a sunny ratio storage step at all mesh positions 31 in a given road segment k is complete (step S8). If not complete, a new mesh position 31 (x, y) is selected, and the procedure returns to step S3.

On the contrary, if determined as complete in step S8, it is determined whether a sunny ratio calculation step is complete for all road segments (step S9). If not complete, the road segment k is updated, and the procedure returns to step S3. If determined as complete in step S9, the procedure of FIG. 5 ends.

As described above, a plurality of mesh positions 31 that correspond to a plurality of solar positions, respectively, and a sunny ratio at each mesh position 31 are stored in the insolation information storage 16, in association with each other, for each of a plurality of regions of interest. The sunny ratio to be stored in the insolation information storage 16 is not data based on time, but data based the solar position. Therefore, as shown in the expression (2), a data amount can be drastically reduced, compared to the storage of the sunny ratio per unit of time.

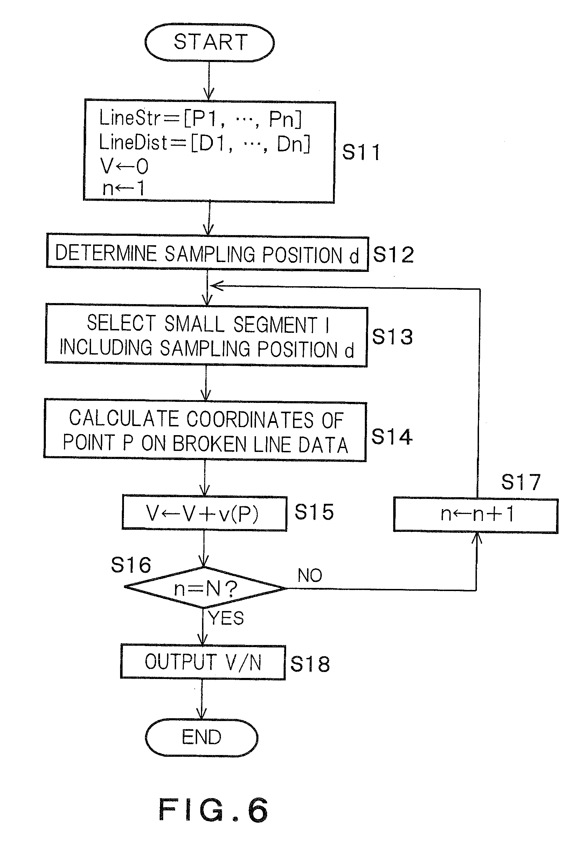

Hereinbelow, step S6 of FIG. 5 will be explained in detail. FIG. 6 is a flowchart showing one example of a detailed process of step S6 in FIG. 5. For example, when the best route is calculated in car navigation, a cost is evaluated with a scalar quantity given to each road segment. As one example, when a route with many sunny or shaded sections is selected as the best route, it is enough to know the sunny or shady ratio per road segment. Then, hereinbelow, an example will be explained in which the sunny ratio is evaluated per moment of movement to a given road segment.

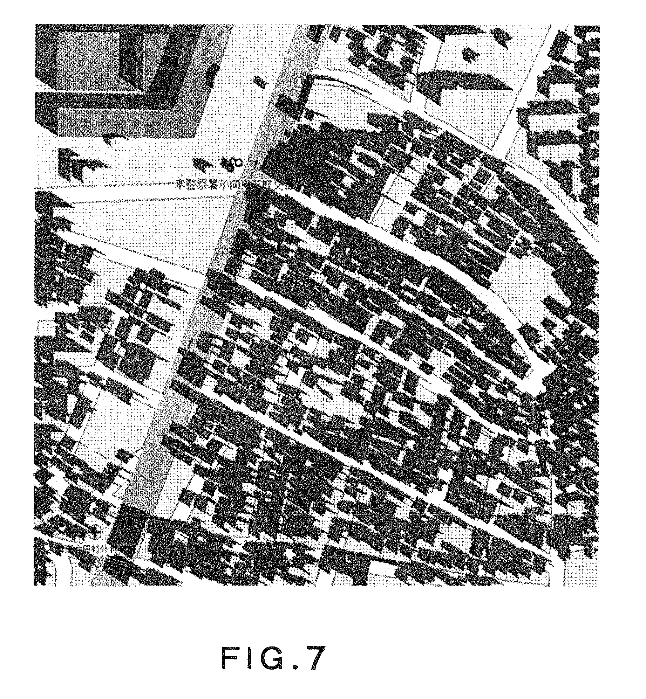

Here, road shape data is given as broken line data. The broken line data is a point sequence of a plurality of points. Each point of the broken line data has binary data that indicates a sunny or shade state. In the flowchart of FIG. 6, a process of acquiring an on-road sunny ratio is performed with pixel sampling calculation with image data that indicates a ground shade range and broken line data that indicates a road position, as input data. FIG. 7 is a diagram showing one example of the image data indicating a ground shade range. This image data was generated by known shadow mapping. The image data creation uses the solar positions obtained in step S5 of FIG. 5 and the three-dimensional information on the feature and road shapes stored in the feature road shape storage 13 of FIG. 5. In summary, regions in which sunlight from the solar positions acquired in step S5 of FIG. 5 is blocked by features are calculated and, based on the calculation results, images of shade on the ground including roads are generated. It is the precondition of the flowchart of FIG. 6 that image data including shade information such as shown in FIG. 7 is generated in advance.

In the flowchart of FIG. 6, firstly, as a pre-process, a distance LineDist from an end point of broken line data LineStr to each point is calculated and a variable V is cleared to zero (step S11), in more specifically, letting LineStr = [P1, $\cdots$, Pn], LineDist = [D1, $\cdots$, Dn], V $\leftarrow$ 0. Pi indicates an i-number point of the broken line data. Di is the distance from the end point to Pi.

Next, a sampling position d on the broken line data LineStr is determined (step S12).

The sampling position d may be determined with uniform random numbers or determined at regular intervals. Next, a small segment i that includes the sampling position d of the broken line data LineStr is selected (step S13), in more specifically, $D(i) \leq d < D(i + 1)$, the initial value of n being 1.

Next, the coordinates of a point P on the broken line data, that corresponds to the sampling position d, is calculated (step S14). The coordinates of the point P can be given by the following expressions (14) and (15).

$$w = (d - D(i)) / (D(i - 1) - D(i)) \cdots (14)$$

$$P \leftarrow w \times P(i) + (1 - w) \times P(i + 1) \cdots (15)$$

Next, as shown in an expression (16), by referring to the image data of FIG. 7, a value v(P) of the sampling point in the image data is added to the variable V by cumulative addition (step S15). v(P) is, for example, 1 for a sunny state and 0 for a shady state.

$$V \leftarrow V + v(P) \cdots (16)$$

Next, it is determined whether steps S12 to S15 are repeated by n times (step S16). If the number of loops n has not reached N (n = N) yet, lets n ← n + 1 (step S17) and the procedure returns to step S2. If the number of loops n has reached N, an average value obtained by dividing the variable V by N is output and the procedure ends (step S18). The average value is the sunny ratio. The shady ratio can also be acquired with the same procedure.

The sampling procedure shown in FIG. 6 searches for segment numbers many times, and hence, it is preferable to adopt a binary search with a preliminarily-prepared alignment LineDist of distance from the end point to each point.

The sunny ratios and/or shady ratios stored in the insolation information storage 16 with the procedures of FIGS. 5 and 6 can be freely referred to by the insolation information reference device 3 of FIG. 1.

The insolation information reference device 3 of FIG. 1 has a region-of-interest specifying module 21, a reference date-and-time specifying module 22, a solar position calculator (a second solar position calculator) 23, a coordinate transformer 24, a mesh position selector 25, and an insolation information acquisition module 26.

The region-of-interest specifying module 21 specifies a region of interest for which at least either one of the sunny ratio and the shady ratio is to be calculated. The reference date-and-time specifying module 22 specifies a reference date and time. The solar position calculator 23 calculates a solar altitude and a solar azimuth that represent the solar position at the reference date and time.

The coordinate transformer 24 transforms the solar position expressed by the solar altitude and solar azimuth calculated by the solar position calculator 23 into two-dimensional coordinates on the two-dimensional plane. The mesh position selector 25 selects a mesh position 31 for which at least either the sunny ratio or the shady ratio is to be acquired, based on the two-dimensional coordinates transformed by the coordinate transformer 24.

The insolation information acquisition module 26 acquires at least either the sunny ratio or the shady ratio corresponding to the mesh position 31 selected by the mesh position selector 25, from the insolation information storage 16.

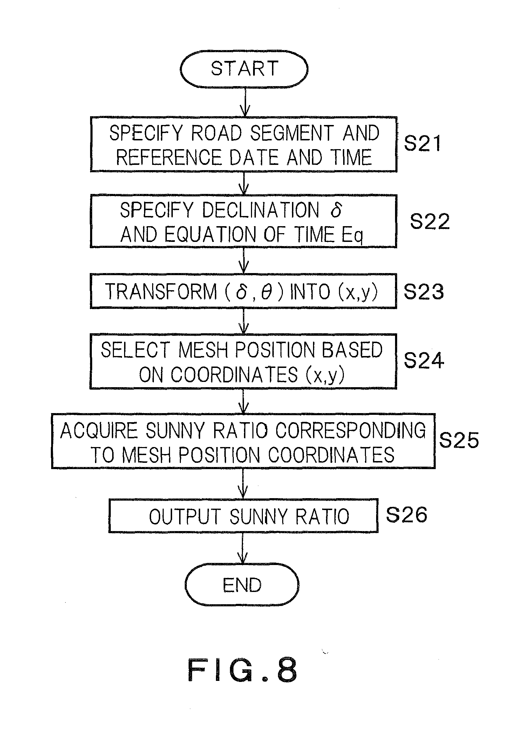

FIG. 8 is a flowchart showing one example of a procedure performed by the insolation information reference device 3 of FIG. 1.

Firstly, the region-of-interest specifying module 21 specifies a road segment e and the reference date-and-time specifying module 22 specifies a reference date and time dt (step S21).

Next, based on the reference date and time dt, the solar position calculator 23 calculates a declination $\delta$ and an equation of time Eq according to the following step (Step S22). Using an angle $\theta o = 2\pi \times (dn - 1) / 365$ defined by the number of days dn (dn = 1 on New Year's Day) from the New Year's Day, the declination $\delta$ and the equation of time Eq of the sun are given by the following expressions (17) and (18) that are empirical formulae.

$$\text{Declination } \delta = 0.006918 - 0.39912 * \cos(\theta o)$$
$$+ 0.070257 * \sin(\theta o) - 0.006758 * \cos(2\theta o)$$
$$+ 0.000907 * \sin(2\theta o) - 0.002697 * \cos(3\theta o)$$
$$+ 0.001480 * \sin(3\theta o) \cdots (17)$$

$$\text{Equation of time } Eq = 0.000075 + 0.001868 * \cos(\theta o)$$
$$- 0.032077 * \sin(\theta o) - 0.014615 * \cos(2\theta o)$$
$$- 040849 * \sin(2\theta o) \cdots (18)$$

The equation of time is a numerical value of time into which the difference between the positions of an apparent sun and a mean sun is converted. The apparent sun is the sun actually observed. The mean sun is a pseudo-sun that moves on the celestial sphere at uniform velocity. The factors for causing the equation of time are that the orbital path of the earth to revolve around the sun is an ellipse and the axis of earth is tilted about 23 degrees.

Using an equation of time Eq and a longitude $\Phi$ of a road segment, a solar azimuth $\theta$ is given by the following expression (19).

$$\theta = (hn - 12) / 12 \times \pi + (\Phi - 135) / 180 \times \pi + Eq \cdots (19)$$

Next, based on the following expression (20), the coordinate transformer 24 transforms (declination $\delta$, hour angle $\theta$) into two-dimensional coordinates (x, y) (step S23).

$$(x, y) = GI(\delta, \theta) \cdots (20)$$

The function ($\delta$, $\theta$) of the expression (20) is expressed by the following expressions (21) and (22), in more specifically.

$$y = \delta \cdots (21)$$

$$X = \cos(\delta) \times \theta \cdots (22)$$

Next, based on the coordinates (x, y) transformed in step S23, the mesh position selector 25 selects one mesh position 31 within the frame line 32 of FIG. 3 (step S24). For example, the mesh position selector 25 selects a mesh position 31 located near the coordinates (x, y). The mesh position coordinates (m, n) selected in this case are expressed by the following expressions (23) and (24).

$$m = [x / d] \cdots (23)$$

$$n = [y / d] \cdots (24)$$

As described above, [x] in the expressions (23) and (24) means that x is transformed into an integer, with the fractions after the decimal point rounded down. Instead of transformation into an integer, with the fractions after the decimal point rounded down, x may be rounded off to select the mesh position 31 nearest to the coordinates (x, y).

Next, the insolation information acquisition module 26 acquires the sunny ratio that corresponds to the mesh position coordinates (m, n) selected in step S24 from the insolation information storage 16 in the insolation information generating device 2 (step S25) and outputs the acquired sunny ratio (step S26).

In the above-described steps S24 to S26, the following may be performed. A sunny ratio is acquired in step S25 for each of a plurality of mesh positions 31 located around the coordinates (x, y) transformed in step S23. A plurality of acquired sunny ratios are averaged. Then, the final sunny ratio is output in step S26.

FIG. 8 shows an example in which the insolation information reference device 3 acquires and outputs the sunny ratio. However, when the shady ratio is also stored in the insolation information storage 16, the shady ratio can be acquired and outputted in the same procedure.

As described above, the insolation information generating device 2 of the first embodiment generates meshes by projecting the solar trajectory on the celestial sphere onto the mesh positions 31 within the frame line 32 shown in FIG. 3, calculates the sunny ratio that indicates the ratio of each region of interest irradiated with sunlight from the solar position corresponding to each mesh position 31 for each of a plurality of regions of interest, and stores the sunny ratios and the regions of interest in the insolation information storage 16, in association with each other. The sunny ratios stored in the insolation information storage 16 are not the data based on time, but the data based on the solar positions. Therefore, compared with storage of the sunny ratios per unit of time, the data amount in the insolation information storage 16 can be drastically reduced.

Moreover, only by specifying a specific region of interest and a specific reference date and time for a sunny ratio to be acquired, the insolation information reference device 3 can acquires the corresponding sunny ratio from the insolation information storage 16. Accordingly, the sunny ratio in any region of interest and at any reference date and time can be easily acquired and, using the sunny ratio, a variety of kinds of information processing can be performed in short time.

(Second Embodiment)

At least either one of the sunny ratio and the shady ratio acquired by the insolation information reference device 3 according to the first embodiment can be used in a variety of application fields. In the following, as one example, a procedure of a navigator to search for the best route with the least energy consumption by using the sunny ratio and shady ratio acquired by the insolation information reference device 3 described above, will be explained.

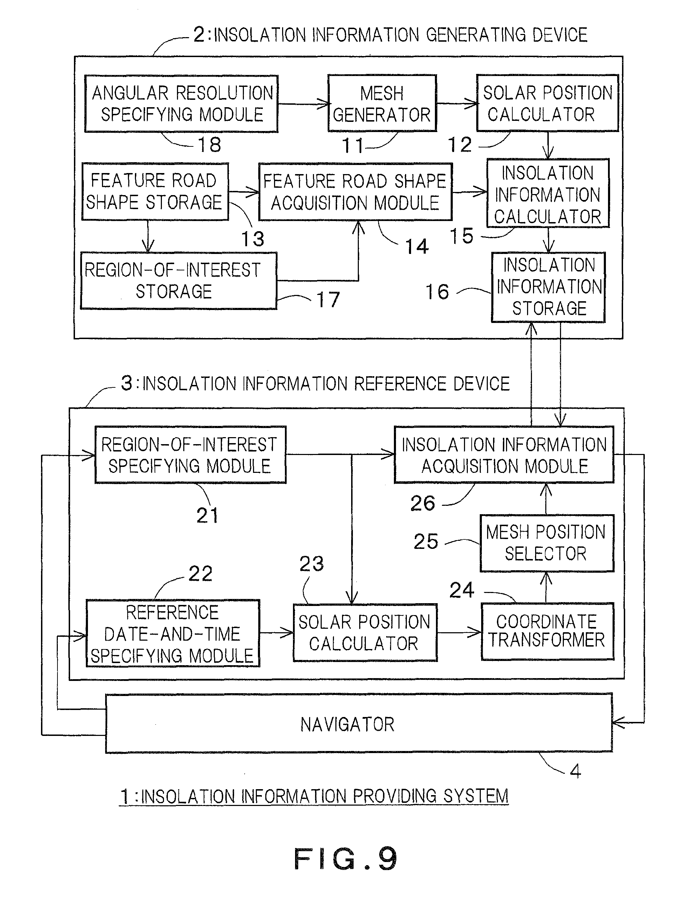

FIG. 9 is a schematic block diagram of an insolation information providing system 1 according to a second embodiment. The insolation information providing system 1 of FIG. 9 has a navigator 4 in addition to the configuration of FIG. 1.

Hererinbelow, a procedure of the navigator 4 of FIG. 9 will be explained in detail. As a precondition, a function $G = (V, E)$ that expresses a road network is given. The variable V is an end point of each road segment and E is a side of each road segment. The navigator 4 according to the present embodiment selects a route with the minimum cost that is the total amount of energy consumption. The known Dijkstra's algorithm or the like can be used for cost calculation. In the following procedure, a power-regenerative electric vehicle (EV) or hybrid vehicle (HV) is the precondition.

When a road segment's sunny ratio $S = w1$ is given, energy consumption $Cost(v, L, N, S)$ for running a road segment having a length L at a velocity v is expressed by the following expression (25) where N is the number of times of running or stopping per road segment.

$$Cost(v, L, N, S) = CostDV(v, L, N) + CostAC(v, L, S) \cdots (25)$$

$CostDV(v, L, N)$ of the first term on the right side is energy consumption due to vehicle driving, which is, in more specifically, expressed by the following expression (26).

$$Cost(v, L, N, S) = R(v) \times L + (1 - \alpha) \times K(v) \times N \cdots (26)$$

In the expression (26), $R(v)$ is running resistance, $\alpha$ is a regeneration ratio, and $K(v)$ is kinetic energy, which are expressed by the following expressions (27) to (29), respectively, where k is drag coefficient, m is vehicle weight, g is gravitational acceleration, $\mu$ is rolling resistance coefficient, and $\theta$ is road grade. $\cdots$ (27)

$$R(v) = k \times v \times v + m \times g \times (\mu + \sin\theta) \cdots (27)$$

$$\alpha \approx 0.25 \cdots (28)$$

$$K(v) = m \times v \times v / 2 \cdots (29)$$

By dividing each side of the expression (26) by L, a cost function CostDV/L expressed by the following expression (30) is given.

$$CostDV/L = R(v) + (1 - \alpha) \times K(v) \times n \cdots (30)$$

where n is the number of times of stopping per unit of distance, $n \approx 5$ times / km.

$CostAC(v, L, S)$ of the second term on the right side of the expression (25) is energy consumption of a vehicle air conditioner, which is, in more specifically, expressed by the following expression (31).

$$CostAC(v, L, S) = P0 \times (L0 / v) + P1 \times (L1 / v) \cdots (31)$$

In the expression (31), L0 is a shady segment of a road segment and L1 is a sunny segment of the road segment, which gives a road segment L = L0 + L1. A shady ratio w0 is expressed by L0 / L1 and a sunny ratio w1 is expressed by L1 / L. Thus, L0 and L1 can be easily calculated using the sunny ratio and shady ratio acquired by the insolation information reference device 3 according to the first embodiment. Since L0 + L1 = L, it is possible for the insolation information reference device 3 to calculate both of L0 and L1, as long as acquiring either one of the sunny ratio and the shady ratio.

Moreover, in the expression (31), P0 is power consumption of an air conditioner while running in shady regions and P1 is power consumption of the air conditioner while running in sunny regions.

By dividing each side of the above-mentioned expression (31) by L, a cost function CostAC/L expressed by the following expression (32) is given.

$$\mathrm{CostAC/L} = (\mathrm{w0} \times \mathrm{P0} + \mathrm{w1} \times \mathrm{P1}) / \mathrm{v} \cdots (32)$$

The navigator 4 selects a route for which the addition of the expressions (31) and (32) becomes minimum as the best route with the least energy consumption.

The navigator 4 may not always use the sunny ratio stored in the insolation information storage 16 in searching for a route with the least energy consumption. For example, the sunny ratio per road segment may be used for selecting a route of the highest shady ratio from the place of departure to the place of destination as the best route, in order to restrict the in-vehicle temperature increase in summer. Moreover, when a vehicle is equipped with a solar panel, a route of the highest sunny ratio from the place of departure to the place of destination may be selected as the best route, in order to maximize the power of the solar panel.

As described above, according to the second embodiment, by using the insolation information storage 16, the sunny ratio per road segment can be easily acquired, and hence a cost per road segment can be easily determined based on the acquired sunny ratio to find out the best route from the place of departure to the place of destination in short time.

At least part of the insolation information providing system 1 explained in the embodiment may be configured with hardware or software. When it is configured with software, a program that performs at least part of the functions of the insolation information providing system 1 may be stored in a storage medium such as a flexible disk and CD-ROM, and then installed in a computer to run thereon. The storage medium may not be limited to a detachable one such as a magnetic disk and an optical disk but may be a standalone type such as a hard disk drive and a memory.

Moreover, a program that achieves the function of at least part of the insolation information providing system 1 may be distributed via a communication network (including wireless communication) such as the Internet. The program may also be distributed via an online network such as the Internet or a wireless network, or stored in a storage medium and distributed under the condition that the program is encrypted, modulated or compressed.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the spirit of the inventions. The accompanying claims and their equivalents are intended to cover such forms or modifications as would fall within the scope and spirit of the inventions.

**Claims**

1.   An insolation information generating device comprising:

a mesh generator to generate meshes by projecting a solar trajectory on a celestial sphere onto a plurality of mesh positions on a two-dimensional plane;
a solar position calculator to calculate a solar position expressed by a solar altitude and a solar azimuth for each mesh position in the meshes;
a feature road shape storage to store three-dimensional information on feature and road shapes;
a feature road shape acquisition module to acquire three-dimensional information of a feature and a road located around each of a plurality of regions of interest from the feature road shape storage;
an insolation information calculator to determine whether sunlight from each solar position calculated by the solar position calculator is blocked by a feature acquired by the feature road shape acquisition module in each region of interest and to calculate at least either one of a sunny ratio that indicates how much each region of interest is irradiated with the sunlight with respect to an area of the region of interest and a shady ratio that indicates how much each region of interest is not irradiated with the sunlight with respect to the area of the region of interest; and

an insolation information storage to store each mesh position and at least either one of the corresponding sunny ratio and shady ratio in association with each other, for each of the plurality of regions of interest.

2. The insolation information generating device of claim 1, further comprising:

a region of interest storage to extract and store the plurality of regions of interest from the three-dimensional information on the feature and road shapes stored in the feature road shape storage,
wherein the feature road shape acquisition module acquires three-dimensional information of a feature and a road located around each of the plurality of regions of interest stored in the region of interest storage, from the region of interest storage,
the insolation information calculator calculates at least either one of the sunny ratio and the shady ratio for each of the plurality of regions of interest stored in the region of interest storage, and
the insolation information storage stores each mesh position and at least either one of the corresponding sunny ratio and shady ratio in association with each other, for each of the plurality of regions of interest stored in the region of interest storage.

3. The insolation information generating device of claim 1, further comprising:

an hour angle and declination transformer to transform two-dimensional coordinates that express each mesh positon generated by the mesh generator into an hour angle and declination on the celestial sphere,
wherein the solar position calculator calculates the solar position expressed by the solar altitude and the solar azimuth based on the hour angle and the declination transformed by the hour angle and declination transformer.

4. The insolation information generating device of claim 1, further comprising:

an angular resolution specifying module to specify angular resolution that expresses an interval of solar positions on the celestial sphere,
wherein the mesh generator sets an interval of mesh positions adjacent to each other based on the angular resolution specified by the angular resolution specifying module.

5. The insolation information generating device of claim 1, wherein each of the plurality of regions of interest is at least one of a surface having a width and a length, a line segment having a specific length with no width, and a point having no width and length.

6. The insolation information generating device of claim 5, wherein, when each region of interest is the line segment, the insolation information calculator determines whether each of a plurality of points of the line segment is sunny or shady to convert each point into a numerical value and calculates at least either one of the sunny ratio and the shady ratio by means of an average of numerical values of the plurality of points.

7. An insolation information providing system comprising an insolation information generating device and an insolation information reference device,
wherein the insolation information generating device comprises:

a mesh generator to generate meshes by projecting a solar trajectory on a celestial sphere onto a plurality of mesh positions on a two-dimensional plane;
a first solar position calculator to calculate a solar position expressed by a solar altitude and a solar azimuth for each mesh position in the meshes;
a feature road shape storage to store three-dimensional information on feature and road shapes;
a feature road shape acquisition module to acquire three-dimensional information of a feature and a road located around each of a plurality of regions of interest from the feature road shape storage;
an insolation information calculator to determine whether sunlight from each solar position calculated by the first solar position calculator is blocked by a feature acquired by the feature road shape acquisition module in each region of interest and to calculate at least either one of a sunny ratio that indicates how much each region of interest is irradiated with the sunlight with respect to an area of the region of interest and a shady ratio that indicates how much each region of interest is not irradiated with the sunlight with respect to the area of the region of interest; and

an insolation information storage to store each mesh position and at least either one of the corresponding sunny ratio and shady ratio in association with each other, for each of the plurality of regions of interest, and

the insolation information reference device comprises:

a region-of-interest specifying module to specify a region of interest for which at least either one of the sunny ratio and the shady ratio is to be calculated;

a reference date-and-time specifying module to specify a reference date and time;

a second solar position calculator to calculate a solar position expressed by a solar altitude and a solar azimuth at the reference date and time specified by the reference date-and-time specifying module;

a coordinate transformer to transform the solar position calculated by the second solar position calculator into two-dimensional coordinates on the two-dimensional plane;

a mesh position selector to select the mesh position for which at least either of the sunny ratio and the shady ratio is to be acquired, based on the two-dimensional coordinates transformed by the coordinate transformer;

an insolation information acquisition module to acquire at least either of the sunny ratio and the shady ratio corresponding to the mesh position selected by the mesh position selector, from the insolation information storage.

8. The insolation information providing system of claim 7, wherein the mesh position selector selects the mesh position nearest to the two-dimensional coordinates transformed by the coordinate transformer.

9. The insolation information providing system of claim 7, wherein the mesh position selector selects a plurality of mesh positions within a specific distance from the two-dimensional coordinates transformed by the coordinate transformer, and

the insolation information acquisition module averages at least either one of the sunny ratio and the shady ratio acquired for each the plurality of mesh positions selected by the mesh position selector.

10. The insolation information providing system of claim 9, wherein the plurality of regions of interest include a plurality of road segments from a first spot to a second spot,

wherein the insolation information providing system further comprises a best route searching module to search for a best route from the first spot to the second spot based on at least either one of the sunny ratio and the shady ratio that corresponds to each of the plurality of road segments output by the insolation information acquisition module.

11. An insolation information providing method of acquiring at least either one of a sunny ratio and a shady ratio for a plurality of regions of interest generated by an insolation information generating device, by an insolation information reference device,

wherein the insolation information generating device

generates meshes by projecting a solar trajectory on a celestial sphere onto a plurality of mesh positions on a two-dimensional plane;

calculates a solar position expressed by a solar altitude and a solar azimuth for each of the plurality of mesh positions;

acquires three-dimensional information of a feature and a road located around each of a plurality of regions of interest from a feature road shape storage to store three-dimensional information on feature and road shapes;

determines whether sunlight from each solar position thus calculated is blocked by the acquired feature in each region of interest and calculates at least either one of a sunny ratio that indicates how much each region of interest is irradiated with the sunlight with respect to an area of the region of interest and a shady ratio that indicates how much each region of interest is not irradiated with the sunlight to the area of the region of interest; and

stores each mesh position and at least either one of the corresponding sunny ratio and shady ratio in association with each other, for each of the plurality of regions of interest,

the insolation information reference device

specifies a region of interest for at least either one of the sunny ratio and the shady ratio is to be calculated;

specifies a reference date and time;

calculates a solar position expressed by a solar altitude and a solar azimuth at the specified reference date and time;

transforms the calculated solar position into two-dimensional coordinates on the two-dimensional plane;

selects the mesh position for which at least either one of the sunny ratio and the shady ratio is to be acquired, based on the transformed two-dimensional coordinates;

acquires at least either one of the sunny ratio and the shady ratio that corresponds to the selected mesh position, from the insolation information storage; and

outputs at least either one of the sunny ratio and the shady ratio as being associated with the specified region of interest.

**2:INSOLATION INFORMATION GENERATING DEVICE**

| ANGULAR RESOLUTION SPECIFYING MODULE | MESH GENERATOR | SOLAR POSITION CALCULATOR |
|---|---|---|

18  11  12

| FEATURE ROAD SHAPE STORAGE | FEATURE ROAD SHAPE ACQUISITION MODULE | INSOLATION INFORMATION CALCULATOR |
|---|---|---|

13  14  15

| REGION-OF-INTEREST STORAGE | | INSOLATION INFORMATION STORAGE |
|---|---|---|

17  16

**3:INSOLATION INFORMATION REFERENCE DEVICE**

| REGION-OF-INTEREST SPECIFYING MODULE | INSOLATION INFORMATION ACQUISITION MODULE |
|---|---|

21  26

25  MESH POSITION SELECTOR

22

| REFERENCE DATE-AND-TIME SPECIFYING MODULE | SOLAR POSITION CALCULATOR | COORDINATE TRANSFORMER |
|---|---|---|

23  24

**1:INSOLATION INFORMATION PROVIDING SYSTEM**

# FIG.1

FIG.2

FIG.3

EP 2 924 475 A1

FIG. 4

START

SPECIFY ANGULAR RESOLUTION d | S1

GENERATE MESHES | S2

TRANSFORM MESH POSITION
NUMBER (m,n) INTO COORDINATES (x,y) | S3

TRANSFORM COORDINATES (x,y) INTO
(DECLINATION δ, HOUR ANGLE θ) | S4

TRANSFORM (δ, θ)INTO (SOLAR
ALTITUDE α, SOLAR AZIMUTH β) | S5

CALCULATE SUNNY RATIO S(k) OF ROAD SEGMENT k | S6

STORE SUNNY RATIO S(k) IN INSOLATION INFORMATION
STORAGE IN ASSOCIATION WITH MESH POSITION | S7

S8
IS SUNNY RATIO
CALCULATED AT ALL MESH POSITION IN ROAD
SEGMENT k? — NO

YES

S9
IS SUNNY
RATIO CALCULATED FOR ALL ROAD
SEGMENTS? — NO

YES

END

# FIG.5

START

LineStr＝[P1, …, Pn]
LineDist＝[D1, …, Dn]
V←0
n←1
    S11

DETERMINE SAMPLING POSITION d | S12

SELECT SMALL SEGMENT I
INCLUDING SAMPLING POSITION d | S13

CALCULATE COORDINATES OF
POINT P ON BROKEN LINE DATA | S14

V←V+v(P)  S15

S16 n=N? —— NO

S17
n←n+1

YES

OUTPUT V/N  S18

END

FIG.6

FIG.7

START

SPECIFY ROAD SEGMENT AND
REFERENCE DATE AND TIME | S21

SPECIFY DECLINATION $\delta$
AND EQUATION OF TIME Eq | S22

TRANSFORM ($\delta, \theta$) INTO (x,y) | S23

SELECT MESH POSITION BASED
ON COORDINATES (x,y) | S24

ACQUIRE SUNNY RATIO CORRESPONDING
TO MESH POSITION COORDINATES | S25

OUTPUT SUNNY RATIO | S26

END

# FIG.8

2:INSOLATION INFORMATION GENERATING DEVICE

| ANGULAR RESOLUTION SPECIFYING MODULE | → | MESH GENERATOR | → | SOLAR POSITION CALCULATOR |

18

11

12

| FEATURE ROAD SHAPE STORAGE | → | FEATURE ROAD SHAPE ACQUISITION MODULE | → | INSOLATION INFORMATION CALCULATOR |

13

14        15

| REGION-OF-INTEREST STORAGE |

17

| INSOLATION INFORMATION STORAGE |

16

3:INSOLATION INFORMATION REFERENCE DEVICE

| REGION-OF-INTEREST SPECIFYING MODULE |

21

| INSOLATION INFORMATION ACQUISITION MODULE |

26

25   | MESH POSITION SELECTOR |

22

23

24

| REFERENCE DATE-AND-TIME SPECIFYING MODULE | → | SOLAR POSITION CALCULATOR | → | COORDINATE TRANSFORMER |

| NAVIGATOR |

4

1:INSOLATION INFORMATION PROVIDING SYSTEM

FIG.9

Europäisches
Patentamt
European
Patent Office
Office européen
des brevets

# EUROPEAN SEARCH REPORT

Application Number

EP 15 15 9184

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/105045 A1 (WORO AARON WILLIAM [US]) 8 May 2008 (2008-05-08) * abstract; figure 9 * * paragraphs [0079] - [0091] * ----- | 1-11 | INV. G01W1/12 G06Q10/04 G01C21/34 |
| A | DE 10 2010 042411 A1 (BOSCH GMBH ROBERT [DE]) 19 April 2012 (2012-04-19) * paragraphs [0007] - [0012], [0028] - [0033] * ----- | 1-11 | |
| A | US 2009/125275 A1 (WORO AARON WILLIAM [US]) 14 May 2009 (2009-05-14) * paragraphs [0136] - [0143] * ----- | 1-11 | |

TECHNICAL FIELDS
SEARCHED      (IPC)

G01W
G06Q
F24J
G01C

The present search report has been drawn up for all claims

| Place of search | Date of completion of the search | Examiner |
|---|---|---|
| The Hague | 9 July 2015 | de Bakker, Michiel |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 15 15 9184

This annex lists the patent family members relating to the patent documents cited in the above-mentioned European search report.
The members are as contained in the European Patent Office EDP file on
The European Patent Office is in no way liable for these particulars which are merely given for the purpose of information.

09-07-2015

| Patent document cited in search report | | Publication date | Patent family member(s) | | Publication date |
|---|---|---|---|---|---|
| US 2008105045 | A1 | 08-05-2008 | EP | 2010829 A2 | 07-01-2009 |
| | | | US | 2008105045 A1 | 08-05-2008 |
| | | | WO | 2007127864 A2 | 08-11-2007 |
| DE 102010042411 | A1 | 19-04-2012 | CN | 102445213 A | 09-05-2012 |
| | | | DE | 102010042411 A1 | 19-04-2012 |
| | | | FR | 2973503 A1 | 05-10-2012 |
| US 2009125275 | A1 | 14-05-2009 | EP | 2304836 A1 | 06-04-2011 |
| | | | US | 2009125275 A1 | 14-05-2009 |
| | | | WO | 2009148633 A1 | 10-12-2009 |

EPO FORM P0459

For more details about this annex : see Official Journal of the European Patent Office, No. 12/82